# EUROPEAN PATENT APPLICATION

(11) **EP 4 796 679 A1**
(43) Date of publication of application: **26.08.2026**
(21) Application number: 25700406.9
(22) Date of filing: 17.01.2025
(51) Int. Cl.: C30B 25/12, C30B 25/14

(54) **HEATING CHAMBER AND REACTION CHAMBER**

(30) Priority: 31.12.2024 CN 202411982590
(71) Applicant: Naso Tech (Jiangsu) Co., Ltd, Nantong, Jiangsu 226300 (CN)
(72) Inventor: XIAO, Yunzhang, Nantong, Jiangsu 226300 (CN); HUANG, Shuaishuai, Nantong, Jiangsu 226300 (CN); CHEN, Yifan, Nantong, Jiangsu 226300 (CN); JING, Junhui, Nantong, Jiangsu 226300 (CN); CHEN, Bingan, Nantong, Jiangsu 226300 (CN); ZHONG, Guofang, Nantong, Jiangsu 226300 (CN)
(74) Representative: Murgitroyd & Company
(86) International application number: PCT/CN2025/072918
(87) International publication number: WO 2026/143780

(57) **Abstract**

Disclosed are a heating chamber and a reaction chamber. The heating chamber includes a substrate conveyance channel, configured for conveyance of the substrate. The substrate conveyance channel is formed with a substrate placing position where the substrate is picked or placed. A gas transport and growth chamber is arranged in parallel with the substrate conveyance channel, and the gas transport and growth chamber is formed with an epitaxial growth position for the epitaxial growth of the substrate. A transfer port of the substrate conveyance channel and a gas supply port of the gas transport and growth chamber are located on a same side of the heating chamber. As described above, when a conveying apparatus carries a substrate carrier to enter or exit in the substrate conveyance channel, the conveying apparatus only passes through an upstream space of the reaction chamber and no longer passes through a downstream space of the reaction chamber where a dust-like by-product is produced, so that a surface defect of the substrate caused by particles in the downstream space may be greatly reduced. Meanwhile, the heating chamber is simpler to maintain, and when the heating chamber and the downstream space are cleaned, it is not necessary to separate the conveying apparatus for maintenance.

## Description

### TECHNICAL FIELD

The present disclosure relates to the field of semiconductor technologies, and in particular, to a heating chamber, and further relates to a reaction chamber including the heating chamber.

### BACKGROUND

A raw material of gas in a high-temperature reaction chamber may have a chemical reaction and a dust-like by-product may be generated in a downstream space, that is, an area between a heating chamber and a gas extraction system.

As for an epitaxial reaction apparatus in a conventional technology, at the beginning of each epitaxial growth process, a substrate carrier conveying apparatus needs to place a carrier loaded with a substrate into the heating chamber, passing through a dust-like by-product area in a downstream space. Dust particles and other foreign matters falling in the process may severely degrade the product quality and even lead to product rejection. At the end of each process, the substrate carrier conveying apparatus needs to pick up a product, passing through the dust-like by-product area in the downstream space. The dust particles falling in the process may increase an additional cleaning cost of the apparatus.

### SUMMARY

In view of this, the present disclosure provides a heating chamber and further provides a reaction chamber including the above-mentioned heating chamber, to solve problems of degradation in product quality caused by a dust-like by-product in a downstream space and high device maintenance and cleaning costs.

In order to achieve above-mentioned purpose, the present disclosure provides following technical solutions.

A heating chamber, used for epitaxial growth of a substrate, includes an accommodating space, where the accommodating space is provided with a substrate conveyance channel, configured to convey the substrate, and configured with a substrate placing position where the substrate is picked or placed; and a gas transport and growth chamber, arranged in parallel with the substrate conveyance channel and configured with an epitaxial growth position for epitaxial growth of the substrate; where a transfer port of the substrate conveyance channel and a gas supply port of the gas transport and growth chamber are located on a same side of the heating chamber.

Optionally, according to the above-mentioned heating chamber, the heating chamber further includes a partition plate arranged between the substrate conveyance channel and the gas transport and growth chamber, enabling reaction gas to be separately transported to the epitaxial growth position; where the partition plate is provided with a communication opening for communicating the substrate placing position with the epitaxial growth position.

Optionally, according to the above-mentioned heating chamber, a supporting tray is provided in the heating chamber; and the supporting tray is configured to support the substrate located at the substrate placing position, and the supporting tray is configured to be movable back and forth between the substrate placing position and the epitaxial growth position.

Optionally, according to the above-mentioned heating chamber, the substrate conveyance channel is located below the gas transport and growth chamber; the partition plate is a bottom plate of the gas transport and growth chamber; and an area where the communication opening is located is the epitaxial growth position;

Optionally, according to the above-mentioned heating chamber, the substrate conveyance channel is located above the gas transport and growth chamber; the partition plate is a top plate of the gas transport and growth chamber; a bottom plate of the gas transport and growth chamber is provided with an avoidance opening, and an area where the avoidance opening is located is the epitaxial growth position.

Optionally, according to the above-mentioned heating chamber, the gas transport and growth chamber includes a bottom plate and at least one top plate above the bottom plate, the gas transport and growth chamber is formed by the bottom plate and the at least one top plate; and the at least one top plate is detachably mounted in the heating chamber to change a flow cross-sectional area of the gas transport and growth chamber.

Optionally, according to the above-mentioned heating chamber, the at least one top plate includes a plurality of top plates arranged with intervals.

Optionally, according to the above-mentioned heating chamber, the heating chamber includes a heating chamber body having openings at two ends; the accommodating space is formed in the heating chamber body; and a periphery of the heating chamber body is covered with a thermal insulation member in a sealed manner.

Optionally, according to the above-mentioned heating chamber, supporting partition plates are provided in the heating chamber body near the openings at two ends of the heating chamber body.

Optionally, according to the above-mentioned heating chamber, a supporting frame assembly is disposed at a bottom of the heating chamber; a driving assembly is disposed below the supporting frame assembly; and a transmission rod of the driving assembly is configured to extend into the heating chamber and support the supporting tray.

The present disclosure further provides a reaction chamber, including an upstream space, an epitaxial growth space and a downstream space connected in sequence, where the epitaxial growth space is the accommodating space provided by the heating chamber described above.

Optionally, according to the above-mentioned reaction chamber, the reaction chamber includes a quartz chamber having openings at two ends; where an upstream flange and a downstream flange are respectively connected to the openings at two ends of the quartz chamber via sealed connection; the heating chamber is located in a middle area inside the quartz chamber; a space between the upstream flange and the heating chamber is the upstream space; and a space between the downstream flange and the heating chamber is the downstream space.

Optionally, according to the above-mentioned reaction chamber, a heating coil is wound around a periphery of the quartz chamber corresponding to the heating chamber; and the heating coil is configured to be electrified to inductively heat the heating chamber.

Optionally, according to the above-mentioned reaction chamber, a side wall of the quartz chamber is a hollow structure, and the hollow structure is filled with a cooling liquid.

Optionally, according to the above-mentioned reaction chamber, the upstream flange is provided with a pick-and-place port, and a sealing valve is provided at the pick-and-place port; and an upstream substrate conveyance channel, in communication with the substrate conveyance channel, is provided in the upstream space, and the upstream substrate conveyance channel is in communication with the pick-and-place port of the upstream flange.

Optionally, according to the above-mentioned reaction chamber, an interior of the upstream flange is a hollow structure, and a gas chamber is form by the hollow structure; and the upstream space includes a gas injection pipe in communication with the gas transport and growth chamber, and the gas injection pipe is in communication with the gas chamber.

Optionally, according to the above-mentioned reaction chamber, a gas homogenizing plate is disposed at a position where the gas chamber communicates with the gas injection pipe; a supporting plate is circumferentially fixed in the upstream space; and the supporting plate is provided with a supporting opening for supporting the upstream substrate conveyance channel, and a through hole for the gas injection pipe to pass through.

Optionally, according to the above-mentioned reaction chamber, a gas extraction system in communication with the gas transport and growth chamber is disposed in the downstream space.

Optionally, according to the above-mentioned reaction chamber, the downstream flange is a hollow annular structure, one end opening of the downstream flange is connected to the quartz chamber via sealed connection, and the other end opening is connected to a capping flange via sealed connection; an exhaust channel is formed by the downstream flange; and a tail gas pipeline of the gas extraction system is disposed in the exhaust channel.

Optionally, according to the above-mentioned reaction chamber, the heating chamber includes a side wall and a bottom wall; and the side wall of the heating chamber is an arched structure, and the bottom wall of the heating chamber is a planar structure. The quartz chamber includes a side wall and a bottom wall; and the side wall of the quartz chamber is an arched structure, and the bottom wall of the quartz chamber is a planar structure. A first sealing ring is disposed between the upstream flange and the quartz chamber, and a second sealing ring is disposed between the downstream flange and the quartz chamber. The upstream flange is a hollow structure, and the hollow structure of the upstream flange is filled with a cooling liquid. The downstream flange is a hollow structure, and the hollow structure of the downstream flange is filled with the cooling liquid. The capping flange is a hollow structure, and the hollow structure of the capping flange is filled with the cooling liquid. The capping flange is provided with an observation window and/or a temperature measurement hole. The reaction chamber is provided with a temperature sensor to measure a temperature in the heating chamber.

According to the heating chamber and the reaction chamber provided in the present disclosure, the transfer port of the substrate conveyance channel and the gas supply port of the gas transport and growth chamber are located on the same side of the heating chamber. That is, the transfer port of the substrate conveyance channel is located at a front end of the heating chamber. Correspondingly, a conveying apparatus for conveying a substrate carrier is no longer disposed in a rear section of the heating chamber, that is, a downstream space of the reaction chamber, but is disposed in a front section of the heating chamber, that is, an upstream space of the reaction chamber. As described above, when the conveying apparatus carries the substrate carrier to enter and exit in the substrate conveyance channel, the conveying apparatus only passes through the upstream space of the reaction chamber and no longer passes through the downstream space of the reaction chamber where a dust-like by-product is produced, so that a surface defect of the substrate caused by the particle in the downstream space may be greatly reduced. Meanwhile, the heating chamber is simpler to maintain, and when the heating chamber and the downstream space are cleaned, it is not necessary to separate the conveying apparatus for maintenance.

### BRIEF DESCRIPTION OF THE DRAWINGS

In order to more clearly illustrate embodiments of the present disclosure or the technical solutions in a conventional technology, a brief introduction is given to accompanying drawings required in description of the embodiments or the conventional technology. Obviously, the accompanying drawings in following description are merely embodiments of the present disclosure. For those of ordinary skill in the art, other drawings can be obtained based on the provided drawings without creative efforts.
FIG. 1 is a schematic structural diagram of a heating chamber according to Embodiment 1 of the present disclosure.
FIG. 2 is an exploded view of the heating chamber according to Embodiment 1 of the present disclosure.
FIG. 3 is a schematic structural diagram of a supporting tray located in an epitaxial growth position according to Embodiment 1 of the present disclosure.
FIG. 4 is a schematic structural diagram of the supporting tray located in a substrate placing position according to Embodiment 1 of the present disclosure.
FIG. 5 is a schematic structural diagram of a structure in which a part of top plates are not mounted and the supporting tray is located at the epitaxial growth position according to Embodiment 1 of the present disclosure.
FIG. 6 is a schematic structural diagram of a structure in which a part of the top plates are not mounted and the supporting tray is located at the substrate placing position according to Embodiment 1 of the present disclosure.
FIG. 7 is a schematic structural diagram of a heating chamber according to Embodiment 2 of the present disclosure.
FIG. 8 is an exploded view of the heating chamber according to Embodiment 2 of the present disclosure.
FIG. 9 is a schematic structural diagram of a supporting tray located in an epitaxial growth position according to Embodiment 2 of the present disclosure.
FIG. 10 is a schematic structural diagram of the supporting tray located in a substrate placing position according to Embodiment 2 of the present disclosure.
FIG. 11 is a schematic structural diagram of a supporting tray according to the present disclosure.
FIG. 12 is a schematic structural diagram of a supporting tray according to the present disclosure.
FIG. 13 is a schematic structural diagram of a supporting tray according to the present disclosure.
FIG. 14 is a schematic structural diagram of a reaction chamber according to the present disclosure.

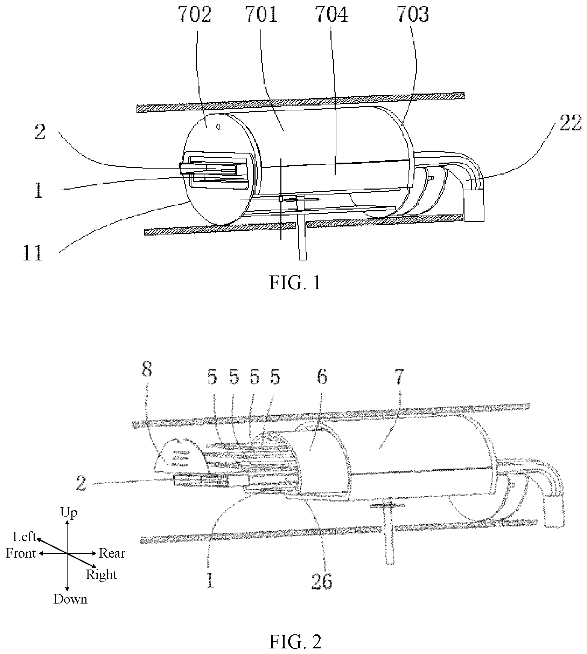

In FIG. 1 to FIG.14:
1. substrate conveyance channel; 2. gas transport and growth chamber; 3. partition plate; 4. supporting tray; 5. top plate; 6. heating chamber body; 7. thermal insulation member; 8. supporting partition plate; 9. supporting frame assembly; 10. transmission rod; 11. heating chamber; 12. quartz chamber; 13. upstream flange; 14. downstream flange; 15. heating coil; 16. sealing valve; 17. upstream substrate conveyance channel; 18. gas injection pipeline; 19. gas injection pipe; 20. gas homogenizing plate; 21. supporting plate; 22. gas extraction system; 23. capping flange; 24. first sealing ring; 25. conveying chamber; 26. side supporting plate;
301. communication opening;
401. tray support; 402. tray surface;
701. first thermal insulation member; 702. second thermal insulation member; 703. third thermal insulation member; 704: fourth thermal insulation member;
801. first supporting partition plate; 802. second supporting partition plate;
1901. first quartz gas inlet section; 1902. graphite gas inlet section; 1903. second quartz gas inlet section;
4021. center plane; 4022. annular surface.

### DETAILED DESCRIPTION OF THE EMBODIMENTS

The present disclosure provides a heating chamber, and further provides a reaction chamber including the heating chamber.

The technical solutions in the embodiments of the present disclosure are clearly and completely described below with reference to the accompanying drawings in the embodiments of the present disclosure. Obviously, the described embodiments are only a part of the embodiments of the present disclosure, not all of them. All other embodiments obtained by a person of ordinary skill in the art based on the embodiments of the present disclosure without creative efforts shall fall within the protection scope of the present disclosure.

As shown in FIGS. 1 to 13, the present disclosure provides a heating chamber. The heating chamber 11 includes an accommodating space. The accommodating space is provided with a substrate conveyance channel 1 and a gas transport and growth chamber 2 arranged in parallel vertically, and a transfer port of the substrate conveyance channel 1 and a gas supply port of the gas transport and growth chamber 2 are located on a same side of the heating chamber. The substrate conveyance channel 1 is configured to convey a substrate, and configured with a substrate placing position where the substrate is picked or placed. The gas transport and growth chamber 2 is arranged in parallel with the substrate conveyance channel 1, and configured with an epitaxial growth position for epitaxial growth of the substrate.

A conveying apparatus is capable of entering and exiting the substrate conveyance channel 1 through the transfer port of the substrate conveyance channel 1. The conveying apparatus is no longer disposed in a rear section of the heating chamber 11, that is, a downstream space of a reaction chamber, but is disposed in a front section of the heating chamber 11, that is, an upstream space of the reaction chamber.

The conveying apparatus is configured to place a carrier carrying the substrate in the substrate placing position, or pick up the carrier carrying the substrate located at the substrate placing position. The substrate may be a wafer.

When the substrate is processed for epitaxial growth in the heating chamber 11, flowing reaction gas is continuously supplied into the gas transport and growth chamber 2 to fully react with the substrate.

When the conveying apparatus carries the substrate carrier to enter and exit the substrate conveyance channel 1, the conveying apparatus may only pass through the upstream space of the reaction chamber and no longer pass through the downstream space of the reaction chamber where a dust-like by-product is produced, so that a surface defect of the substrate caused by the particle in the downstream space may be greatly reduced. Meanwhile, the heating chamber is simpler to maintain, and when the heating chamber and the downstream space are cleaned, it is not necessary to separate the conveying apparatus for maintenance.

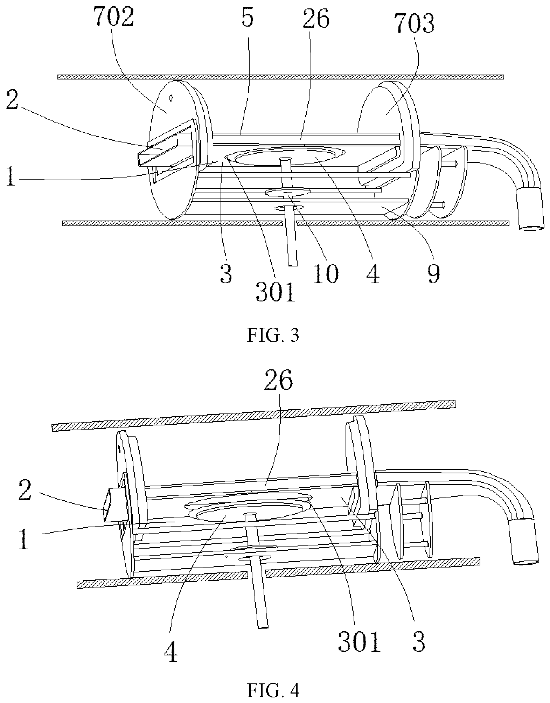

Referring to FIGS. 3 to 6, FIGS. 8 to 10, and FIG. 14, in some embodiments of the present disclosure, the heating chamber further includes an partition plate 3 between the substrate conveyance channel 1 and the gas transport and growth chamber 2, enabling reaction gas to be separately transported to the epitaxial growth position along the substrate conveyance channel 1. The partition plate 3 is provided with a communication opening 301 for communicating the substrate placing position and the epitaxial growth position.

By providing the partition plate 3, the substrate conveyance channel 1 may be isolated from the gas transport and growth chamber 2, so that the reaction gas flowing in the gas transport and growth chamber 2 is maximally prevented from diffusing into the substrate conveyance channel 1. Therefore, whether in a region close to an upstream space or a region close to a downstream space, a large-particle by-product or dust-like by-product may not be produced in the substrate conveyance channel 1 due to contact with the reaction gas. Accordingly, when the conveying apparatus passes through the upstream space of the reaction chamber, a problem of a defect on a surface of the substrate caused by the dust-like by-product in the upstream space may also be effectively avoided.

Referring to FIGS. 3 to 6, and FIGS. 8 to 10, in some embodiments of the present disclosure, a supporting tray 4 is provided in the heating chamber 11. The supporting tray 4 is configured to support a substrate carrier at the substrate placing position (or a substrate, hereinafter, whether the substrate or the substrate carrier is collectively referred to as the substrate carrier), and is configured to be movable back and forth between the substrate placing position and the epitaxial growth position.

In some embodiments, the supporting tray 4 is further capable of rotating.

Referring to FIG. 4, FIG. 6, and FIG. 10, after the supporting tray 4 is moved to the substrate placing position, the conveying apparatus enters the substrate conveyance channel 1, and places the substrate carrier carried by the conveying apparatus on the supporting tray 4, and then the conveying apparatus exits the substrate conveyance channel 1. As shown in FIG. 3, FIG. 5 and FIG. 9, after the substrate carrier is placed on the supporting tray 4, the substrate carrier is driven with the supporting tray 4 to the epitaxial growth position. Then, the substrate carried by the supporting tray 4 is processed for epitaxial growth in the epitaxial growth position. After the process of epitaxial growth is finished, the supporting tray 4 carrying the substrate carrier is moved to the substrate placing position. The conveying apparatus enters the substrate conveyance channel 1 and picks up the substrate carrier located on the supporting tray 4; and then the conveying apparatus carrying the processed substrate may exit the substrate conveyance channel 1.

An accurate, rapid and reliable position switching of a substrate between the substrate placing position and the epitaxial growth position may be realized through the supporting tray 4. The whole moving process may be controlled through a program preset, without manual intervention to contaminate the surface of the substrate, so that the surface of the substrate may be ensured to be clean.

Referring to FIGS. 1 to 6, the heating chamber 11 is a structure with a conveying structure at a lower place. That is, a substrate conveyance channel 1 is located below a gas transport and growth chamber 2. A partition plate 3 is a bottom plate of the gas transport and growth chamber 2, and an area where the communication opening 301 is located is the epitaxial growth position.

In this state, the supporting tray 4 is located in the substrate conveyance channel 1 which is arranged to be at the bottom. After a substrate carrier is placed on the supporting tray 4 located in the substrate placing position, the supporting tray 4 is configured to move upwards to the epitaxial growth position (that is, a location where the communication opening 301 is located). After the epitaxial growth of the substrate is completed at the epitaxial growth position, the supporting tray 4 is configured to move downwards to the substrate placing position.

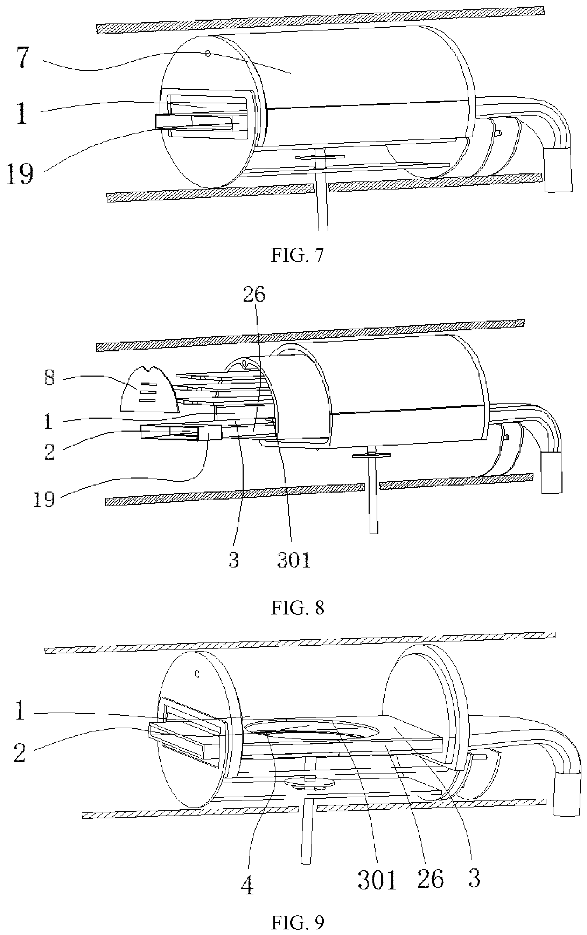

Referring to FIGS. 7 to 10, the heating chamber 11 is a structure with a conveying structure at an upper place. That is, the substrate conveyance channel 1 is located above the gas transport and growth chamber 2. The partition plate 3 is a top plate of the gas transport and growth chamber 2. A bottom plate of the gas transport and growth chamber 2 is provided with an avoidance opening, and an area where the avoidance opening is located is the epitaxial growth position.

In this state, the supporting tray 4 is located in the substrate conveyance channel 1 which is arranged to be at the top. After the substrate carrier is placed on the supporting tray 4, the supporting tray 4 is configured to move downwards through the communication opening 301 to the epitaxial growth position (that is, a location of the avoidance opening). After the epitaxial growth of the substrate is completed at the epitaxial growth position, the supporting tray 4 is configured to move upward through the communication port 301 to the substrate placing position.

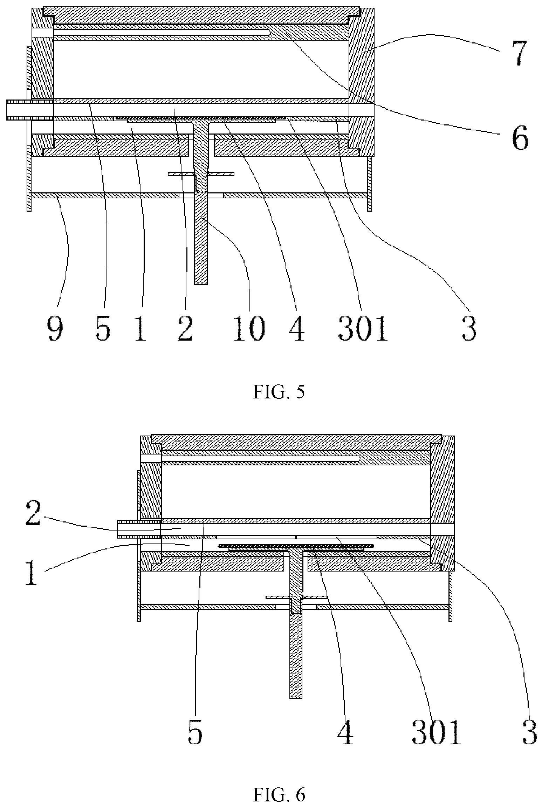

Referring to FIG. 2 and FIG. 6, in some embodiments of the present disclosure, the gas transport and growth chamber 2 includes a bottom plate and at least one top plate 5 above the bottom plate. The gas transport and growth chamber 2 is formed by the bottom plate and the at least one top plate 5. The at least one top plates 5 are arranged with intervals. The top plate 5 is detachably mounted in the heating chamber 11 to change a flow cross-sectional area of the gas transport and growth chamber 2.

Both the bottom plate and the top plate 5 are made of graphite plates.

Furthermore, referring to FIG. 3, when the substrate conveyance channel 1 is located below the gas transport and growth chamber 2, the partition plate 3 is the bottom plate of the gas transport and growth chamber 2. Two side supporting plates 26 are respectively provided on two sides of the partition plate 3 and the top plate 5 in a left-right direction. The gas transport and growth chamber 2 is formed by the two side supporting plates 26, the partition plate 3 and the top plate 5.

Further, referring to FIG. 8, when the substrate conveyance channel 1 is located above the gas transport and growth chamber 2, the gas transport and growth chamber 2 includes a bottom plate. At least one top plate 5 is formed above the bottom plate, and the partition plate 3 is the top plate of the gas transport and growth chamber 2. Two side supporting plates 26 are respectively provided on two sides of the bottom plate and the partition plate 3 in a left-right direction. The gas transport and growth chamber 2 is formed by the two side supporting plates 26, the bottom plate and the partition plate 3.

An inner side wall of the heating chamber 11 is provided with a clamping groove, and the clamping groove is configured to extend in a transport direction of the reaction gas. Two clamping grooves opposite to each other in the left-right direction form a clamping groove group. A plurality of the clamping groove groups are formed in a up-down direction. The bottom plate and the plurality of top plates 5 are sequentially clamped and fixed by the plurality of clamping groove groups.

When the heating chamber 11 is placed in a position shown in FIG. 2, the left-right direction, the up-down direction, and a front-rear direction of the heating chamber 11 are indicated by arrows in FIG. 2.

It should be further noted that when the flow cross-sectional area of the gas transport and growth chamber 2 needs to be gradually increased, the plurality of top plates 5 are sequentially removed from bottom to top.

Of course, the plurality of clamping groove groups are provided in the heating chamber 11 in the present disclosure, so that all the top plates 5 may be removed. Then one of the top plates 5 may be selected to be placed in a clamping groove group at a proper position based on a size of a required flow cross-sectional area of the gas transport and growth chamber 2.

As mentioned above, the flow cross-sectional area of the gas transport and growth chamber 2 may be flexibly adjusted, thereby an optimal process parameter for epitaxial growth of a substrate surface may be verified with different flow cross-sectional areas of a reaction gas.

In some embodiments of the present disclosure, the heating chamber 11 includes a heating chamber body 6 having openings at two ends. The accommodating space is formed by the heating chamber body 6. A periphery of the heating chamber body 6 is covered with a thermal insulation member 7 in a sealed manner.

By covering the periphery of the heating chamber body 6 with the thermal insulation member 7 in the sealed manner, heat generated in the heating chamber body 6 may not be quickly dissipated to the outside, thereby ensuring the substrate to be processed for epitaxial growth under a high-temperature reaction gas condition.

Referring to FIGS. 1 to 2 and FIG. 14, in some embodiments of the present disclosure, the thermal insulation member 7 includes a first thermal insulation member 701 having openings at two ends. The first thermal insulation member 701 is an arched structure, and formed with a bottom opening. Two opposite bottom edges of the first thermal insulation member 701 are respectively provided with a fourth thermal insulation member 704 downward. A gap is formed between the first thermal insulation member 701 and the fourth thermal insulation member 704, so that when a heating coil is disposed on an outer circumference of the heating chamber, an annular current is prevented from being formed on the first thermal insulation member 701 and the fourth thermal insulation member 704 during induction heating of the heating coil. The heating coil will be described in detail in the following. The thermal insulation member 7 may further include a second thermal insulation member 702 and a third thermal insulation member 703 for sealing two ends formed by the first thermal insulation member 701 and the fourth thermal insulation member 704 respectively.

Referring to FIG. 1, furthermore, the second thermal insulation member 702 is provided with a first opening in communication with the transfer port of the substrate conveyance channel 1 and the gas supply port of the gas transport and growth chamber 2. The third thermal insulation member 703 is provided with a second opening in communication with a gas outlet port of the gas transport and growth chamber 2.

In some embodiments, the thermal insulation member 7 is made of a graphite felt material.

In some embodiments of the present disclosure, two supporting partition plates 8 are provided in the heating chamber body 6 near the openings at two ends of the heating chamber body 6.

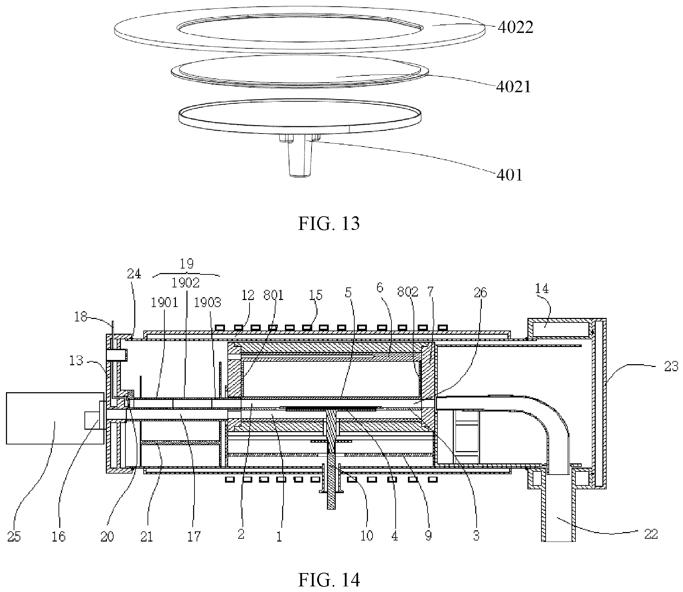

Referring to FIG. 14, it should be noted that the supporting partition plates 8 include a first supporting partition plate 801 close to the second thermal insulation member 702 and a second supporting partition plate 802 close to the third thermal insulation member 703.

Furthermore, the gas supply port of the gas transport and growth chamber 2 and the transfer port of the substrate conveyance channel 1 are not blocked by the first supporting partition plate 801. The gas outlet port of the gas transport and growth chamber 2 is not blocked by the second supporting partition plate 802.

The heating chamber body 6 is isolated from the second thermal insulation member 702 and the third thermal insulation member 703 by the first supporting partition plate 801 and the second supporting partition plate 802 respectively, so that a graphite particle falling from the second thermal insulation member 702 and the third thermal insulation member 703 is effectively prevented from floating into the accommodating space formed by the heating chamber body 6, and the interior of the heating chamber 11 may be ensured to be clean.

Referring to FIG. 2, in some embodiments, a first mounting position for supporting plate is provided at a first end opening of an inner side wall of the heating chamber body 6, and the first supporting partition plate 801 is fixed to the first mounting position for supporting plate. A second mounting position for supporting plate is provided at a second end opening of the inner side wall of the heating chamber body 6, and the second supporting partition plate 802 is fixed to the second mounting position for supporting plate.

Furthermore, a plurality of first mounting grooves are provided along a circumferential direction of the first end opening of the heating chamber body 6, and a plurality of first protrusions adapted to be clamped and fixed to the plurality of first mounting grooves are formed along the circumferential direction of the first supporting partition plate 801. A plurality of second mounting grooves are formed along a circumferential direction of the second end opening of the heating chamber body 6, and a plurality of second protrusions adapted to be clamped and fixed to the plurality of second mounting grooves are formed in the circumferential direction of the second supporting partition plate 802.

Furthermore, in a sequential arrangement direction of the plurality of top plates 5, a plurality of first supporting grooves are provided on the first supporting partition plate 801, and a plurality of second supporting grooves are provided on the second supporting partition plate 802. As for a part of the top plates 5, one end of the top plate 5 is clamped to the first supporting groove, and the other end of the top plate 5 is clamped to the second supporting groove.

Referring to FIG. 1, FIGS. 3 to 6, FIGS. 7 to 10, and FIG. 14, in some embodiments of the present disclosure, a supporting frame assembly 9 is provided at a bottom of the heating chamber 11. A driving assembly is provided below the supporting frame assembly 9. The transmission rod 10 located at a top end of the driving assembly is located at a central axis of the heating chamber. The driving assembly has lifting and rotating functions, so that the supporting tray 4 may be driven by the transmission rod 10 to perform lifting and rotating actions. The transmission rod 10 of the driving assembly is configured to extend into the heating chamber and support the supporting tray 4.

The supporting frame assembly 9 is a quartz boat support structure.

The supporting frame assembly 9 is positioned in coordination with a central axis of a quartz chamber to ensure that positions of the supporting frame assembly 9 and the heating chamber 11 are fixed each time when the supporting frame assembly 9 and the heating chamber 11 are installed, so as to reproduce consistency of process results of each batch.

A hole is provided in the middle of a bottom surface of the heating chamber 11. The transmission rod 10 of the driving assembly may extend into the interior of the heating chamber 11 in a sealed manner.

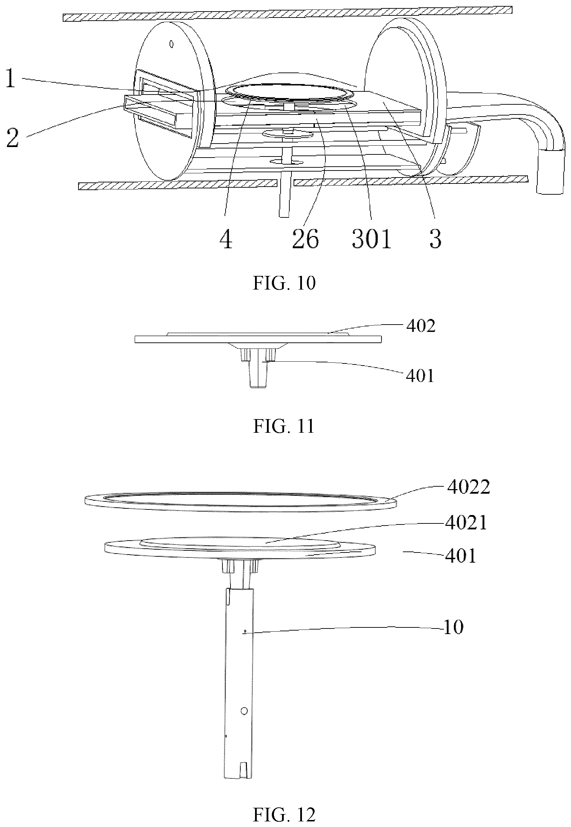

In some embodiments, referring to FIG. 11, the supporting tray 4 of the present disclosure includes a tray support 401 and a tray surface 402, and the tray support 401 is fixed to the transmission rod 10. Referring to FIG. 11, the tray surface 402 is an integrated structure, and the tray surface 402 is fixed to the tray support 401. Alternatively, referring to FIGS. 12 to 13, the tray surface 402 is a combined structure, and consists of two components. That is, the tray surface 402 includes a center surface 4021 and an annular surface 4022. The annular surface 4022 is located on an outer circumference of the center surface 4021, the center surface 4021 is fixed on the tray support 401. The annular surface 4022 can be detachably mounted on the tray support 401. Since an edge of the tray surface 402 is prone to be contaminated by gas used for epitaxial growth during an epitaxial growth process of a wafer, the tray surface 402 needs to be replaced regularly. As the tray surface 402 is in a form of a combination of the central surface 4021 and the detachably mounted annular surface 4022, a material cost caused by regularly replacing the tray surface 402 may be reduced, and it is more convenient and fast to replace and install.

Referring to FIG. 14, in view of above, the present disclosure further provides a reaction chamber. The reaction chamber includes an upstream space, an epitaxial growth space, and a downstream space connected in sequence. The epitaxial growth space is the accommodating space formed by the heating chamber 11 described above.

Since the reaction chamber of the present disclosure includes the heating chamber 11 described above, beneficial effects of the reaction chamber brought by the heating chamber 11 may be referred to the above description, and details are not described herein again.

In some embodiments of the present disclosure, the reaction chamber includes a quartz chamber 12 having openings at two ends. An upstream flange 13 and a downstream flange 14 are respectively connected to two openings at two ends of the quartz chamber 12 via sealed connection. The heating chamber 11 is located in a middle area inside the quartz chamber 12. A space between the upstream flange 13 and the heating chamber 11 is the upstream space. A space between the downstream flange 14 and the heating chamber 11 is the downstream space.

According to the present disclosure, the upstream space, the epitaxial growth space and the downstream space that are sequentially connected and sealed are obtained through a combined structure of the quartz chamber 12, the upstream flange 13 and the downstream flange 14. Not only is the combined structure simple, but also it is ensured that an interior of the reaction chamber remains in a vacuum environment.

In some embodiments of the present disclosure, a heating coil 15 is wound around a periphery of the quartz chamber 12 corresponding to the heating chamber 11. The heating coil 15 is configured to be electrified to inductively heat the heating chamber 6.

The heating coil 15 fixed on an outer side of the quartz chamber 12 provides non-contact heating to the heating chamber body 6 of the heating chamber 11.

Furthermore, as the periphery of the heating chamber body 6 is covered by the thermal insulation member 7, the thermal insulation member 7 may prevent heat generated by the heating chamber body 6 from dissipating to the quartz chamber 12, so that a temperature of a position of the quartz chamber 12 corresponding to the heating chamber body 6 is prevented from being too high. Meanwhile, it is ensured that a certain gap exists between the thermal insulation member 7 and the quartz chamber 12, so that it can be effectively avoided that the thermal insulation member 7 is crushed by an expanded heating chamber body 6.

In some embodiments of the present disclosure, a side wall of the quartz chamber 12 is a hollow structure. The hollow structure is filled with a cooling liquid.

As described above, the quartz chamber 12 may be cooled to avoid a risk of scald to an operator caused by a high temperature of an outer surface of the quartz chamber.

Referring to FIG. 14, in some embodiments of the present disclosure, the upstream flange 13 is provided with a pick-and-place port. A sealing valve 16 is provided at the pick-and-place port. The upstream space includes an upstream substrate conveyance channel 17 in communication with the substrate conveyance channel 1, and the upstream substrate conveyance channel 17 is in communication with the pick-and-place port of the upstream flange 13.

The sealing valve 16 is an SV valve. When the sealing valve 16 is opened, a conveying chamber 25, which is configured to support the conveying apparatus, may communicate with the reaction chamber, so that a mechanical arm of the conveying apparatus may enter the reaction chamber from the conveying chamber 25.

Referring to FIG. 14, in some embodiments, an interior of the upstream flange 13 is a hollow structure. A gas chamber is formed by the hollow structure. The upstream space includes a gas injection pipe 19 in communication with the gas transport and growth chamber 2, and the gas injection pipe 19 is in communication with the gas chamber.

It should be noted that a plurality of gas injection pipelines 18 are integrated above the upstream flange 13 to divide a gas supply path into a plurality of zones. The hollow structure of the upstream flange is manufactured to include a plurality of gas chambers and the plurality of gas injection pipelines 18 are respectively communicated with the plurality of gas chambers to separately transport the reaction gas to the gas transport and growth chamber 2.

It should be further noted that the gas injection pipe 19 may include a first quartz gas inlet section 1901, a graphite gas inlet section 1902 and a second quartz gas inlet section 1903 sequentially communicated. The second quartz gas inlet section 1903 is in communication with the gas transport and growth chamber 2.

Furthermore, the pick-and-place port of the upstream flange 13 is formed below the gas chamber formed by the upstream flange 13. That is, the mechanical arm of the conveying apparatus in the conveying chamber 25 may place the substrate (that is, the wafer) into the high-temperature reaction chamber in a path below the gas injection pipe 19.

In some embodiments, a gas homogenizing plate 20 is disposed at a position where the gas chamber communicates with the gas injection pipe 19.

It should be noted that the gas homogenizing plate 20 includes a plate body and a plurality of ventilation holes provided in the plate body. The gas homogenizing plate 20 is in communication with the first quartz gas inlet section 1901.

As described above, the reaction gas may be rapidly dissipated to the gas injection pipe 19, so that a uniform flow of gas is formed in the gas injection pipe 19.

In some embodiments, a supporting plate 21 is circumferentially fixed in the upstream space. The supporting plate 21 is provided with a supporting opening for supporting the upstream substrate conveyance channel 17, and a through hole for the gas injection pipe 19 to pass through.

As described above, the gas injection pipe 19 may be supported and fixed by the supporting plate 21. Meanwhile, an avoidance space is formed for free entry and exit of the mechanical arm of the conveying apparatus.

In some embodiments of the present disclosure, a gas extraction system 22 in communication with the gas transport and growth chamber 2 is disposed in the downstream space.

It should be noted that, after the sealing valve 16 is closed, under action of a process pump in a tail gas pipeline of the gas extraction system 22, the reaction chamber may be maintained within a stable process pressure range.

In some embodiments of the present disclosure, the downstream flange 14 is a hollow annular structure. One end opening of the downstream flange 14 is connected to the quartz chamber 12 via sealed connection, and the other end opening is connected to a capping flange 23 via sealed connection. An exhaust channel is formed by the downstream flange 14, and the tail gas pipeline of the gas extraction system 22 is disposed in the exhaust channel.

It should be noted that the capping flange 23 is connected with the downstream flange 14, and a vacuum space in the reaction chamber is formed by the capping flange 23, the quartz chamber 12 and the upstream flange 13.

By providing the exhaust channel at a bottom of the downstream flange 14, a gas flow inside the heating chamber 11 may be pumped away, so as to maintain a relatively stable pressure within the heating chamber 11. By providing the capping flange 23, the downstream space may be exposed, thereby facilitating cleaning and maintenance of the downstream space.

In some embodiments of the present disclosure, the heating chamber 11 may include a side wall and a bottom wall. The side wall of the heating chamber 11 is an arched structure, and the bottom wall of the heating chamber 11 is a planar structure.

Furthermore, the quartz chamber 12 may include a side wall and a bottom wall. The side wall of the quartz chamber 12 is an arched structure, and the bottom wall of the quartz chamber 12 is a planar structure.

As described above, the bottom of the heating chamber 11 and the bottom of the quartz chamber 12 are both planar structures, facilitating support and fixation on the supporting frame assembly 9 (that is the quartz boat support structure).

In some embodiments, a first sealing ring 24 is disposed between the upstream flange 13 and the quartz chamber 12. Furthermore, a second sealing ring is disposed between the downstream flange 14 and the quartz chamber 12. By providing the first sealing ring 24 and the second sealing ring, sealing effects between the quartz chamber 12 and the upstream flange 13 and between the quartz chamber 12 and the downstream flange 14 are further ensured respectively, and it is ensured that the reaction chamber is maintained in a vacuum environment.

Furthermore, the upstream flange 13 is a hollow structure, and the hollow structure of the upstream flange 13 is filled with a cooling liquid. As described above, a temperature of the upstream flange 13 may be prevented from being too high, and the first sealing ring 24 located at a position of the gas homogenizing plate 20 may be prevented from being damaged by high temperature.

Furthermore, the downstream flange 14 is a hollow structure, and the hollow structure of the downstream flange 14 is filled with a cooling liquid. As described above, a temperature of the downstream flange 14 may be prevented from being too high.

Furthermore, the capping flange 23 is of a hollow structure, and the hollow structure of the capping flange 23 is filled with a cooling liquid. As the capping flange 23 may be relatively high in temperature due to convection heat exchange and radiation from the heating chamber body 6, it usually requires introduction of cooling water.

An observation window and a temperature measurement hole are reserved on the capping flange 23, so that observation and temperature measurement may be performed on the heating chamber body 6 in the heating chamber 11.

In some embodiments, the reaction chamber is provided with a temperature sensor to measure a temperature in the heating chamber 11.

The temperature sensor may be an infrared temperature probe sensor. A lens assembly is disposed on the upstream flange 13. An infrared temperature probe support is mounted on the upstream flange 13. The infrared temperature probe sensor is mounted and fixed on the infrared temperature probe support.

Infrared light emitted by the infrared temperature probe sensor may enter the heating chamber body 6 through lens, so as to measure a temperature inside the heating chamber body 6.

The components and apparatuses involved in the present disclosure are merely illustrative examples and are not intended to require or imply that connections, arrangements, and configurations must be made in the manner shown in the accompanying drawings. As those skilled in the art will recognize, the components and apparatuses may be connected, arranged, configured in any manner. The words such as "comprise"," include"," have"... are open words, refer to "including but not limited to", and may be used interchangeably. The words "or" and "and" as used herein refer to the word "and/or", and may be used interchangeably, unless the context clearly indicates otherwise. The term "such as" used herein refers to the phrase "such as, but not limited to," and may be used interchangeably therewith.

It should further be noted that, in the apparatus of the present disclosure, each component may be decomposed and/or recombined. These decomposition and/or recombination should be considered as equivalent solutions of the present disclosure.

The previous description of the disclosed aspects is provided to enable any person skilled in the art to make or use the present disclosure. Various modifications to these aspects will be readily apparent to those skilled in the art, and the generic principles defined herein may be applied to other aspects without departing from the scope of the present disclosure. Thus, the present disclosure is not intended to be limited to the aspects shown herein but is to be accorded the widest scope consistent with the principles and novel features disclosed herein.

The foregoing description has been presented for purposes of illustration and description. Moreover, the description is not intended to limit the embodiments of the present disclosure to the forms disclosed herein. While various example aspects and embodiments have been discussed above, those skilled in the art will recognize certain variations, modifications, changes, additions, and sub-combinations thereof.

The above description is only preferred embodiments of the present disclosure and is not intended to limit the present disclosure. Any modifications, equivalent substitutions, and the like made within the spirit and principles of the present disclosure should be included in the scope of protection of the present disclosure.

## Claims

1. A heating chamber, used for epitaxial growth of a substrate, comprising an accommodating space, wherein the accommodating space is provided with
a substrate conveyance channel (1), configured to convey the substrate, and configured with a substrate placing position where the substrate is picked or placed; and
a gas transport and growth chamber (2), arranged in parallel with the substrate conveyance channel (1) and configured with an epitaxial growth position for epitaxial growth of the substrate; wherein
a transfer port of the substrate conveyance channel (1) and a gas supply port of the gas transport and growth chamber (2) are located on a same side of the heating chamber.

2. The heating chamber according to claim 1, further comprising a partition plate (3) arranged between the substrate conveyance channel (1) and the gas transport and growth chamber (2), enabling reaction gas to be separately transported to the epitaxial growth position; wherein the partition plate (3) is provided with a communication opening (301) for communicating the substrate placing position with the epitaxial growth position.

3. The heating chamber according to claim 1 or 2, wherein a supporting tray (4) is provided in the heating chamber; and
the supporting tray (4) is configured to support the substrate located at the substrate placing position, and the supporting tray (4) is configured to be movable back and forth between the substrate placing position and the epitaxial growth position.

4. The heating chamber according to claim 2, wherein the substrate conveyance channel (1) is located below the gas transport and growth chamber (2); the partition plate (3) is a bottom plate of the gas transport and growth chamber (2); and an area where the communication opening (301) is located is the epitaxial growth position.

5. The heating chamber according to claim 2, wherein the substrate conveyance channel (1) is located above the gas transport and growth chamber (2); the partition plate (3) is a top plate of the gas transport and growth chamber (2); a bottom plate of the gas transport and growth chamber (2) is provided with an avoidance opening, and an area where the avoidance opening is located is the epitaxial growth position.

6. The heating chamber according to claim 1, wherein the gas transport and growth chamber (2) comprises a bottom plate and at least one top plate (5) above the bottom plate, the gas transport and growth chamber (2) is formed by the bottom plate and the at least one top plate (5); and the at least one top plate (5) is detachably mounted in the heating chamber to change a flow cross-sectional area of the gas transport and growth chamber (2).

7. The heating chamber according to claim 6, wherein the at least one top plate (5) comprises a plurality of top plates (5) arranged with intervals.

8. The heating chamber according to any one of claims 1 to 7, wherein the heating chamber comprises a heating chamber body (6) having openings at two ends; the accommodating space is formed in the heating chamber body (6); and a periphery of the heating chamber body (6) is covered with a thermal insulation member (7) in a sealed manner.

9. The heating chamber according to claim 8, wherein supporting partition plates (8) are provided in the heating chamber body (6) near the openings at two ends of the heating chamber body (6).

10. The heating chamber according to any one of claims 3 to 9, wherein a supporting frame assembly (9) is disposed at a bottom of the heating chamber; a driving assembly is disposed below the supporting frame assembly (9); and a transmission rod (10) of the driving assembly is configured to extend into the heating chamber and support the supporting tray (4).

11. A reaction chamber, comprising an upstream space, an epitaxial growth space and a downstream space connected in sequence, wherein the epitaxial growth space is the accommodating space provided by the heating chamber (11) according to any one of claims 1 to 10.

12. The reaction chamber according to claim 11, comprising a quartz chamber (12) having openings at two ends; wherein an upstream flange (13) and a downstream flange (14) are respectively connected to the openings at two ends of the quartz chamber (12) via sealed connection;
the heating chamber (11) is located in a middle area inside the quartz chamber (12);
a space between the upstream flange (13) and the heating chamber (11) is the upstream space; and
a space between the downstream flange (14) and the heating chamber (11) is the downstream space.

13. The reaction chamber according to claim 12, wherein a heating coil (15) is wound around a periphery of the quartz chamber (12) corresponding to the heating chamber (11); and the heating coil (15) is configured to be electrified to inductively heat the heating chamber.

14. The reaction chamber according to claim 12, wherein a side wall of the quartz chamber (12) is a hollow structure, and the hollow structure is filled with a cooling liquid.

15. The reaction chamber according to claim 12, wherein the upstream flange (13) is provided with a pick-and-place port, and a sealing valve (16) is provided at the pick-and-place port; and
an upstream substrate conveyance channel (17), in communication with the substrate conveyance channel (1), is provided in the upstream space, and the upstream substrate conveyance channel (17) is in communication with the pick-and-place port of the upstream flange (13).

16. The reaction chamber according to claim 15, wherein an interior of the upstream flange (13) is a hollow structure, and a gas chamber is form by the hollow structure; and
the upstream space comprises a gas injection pipe (19) in communication with the gas transport and growth chamber (2), and the gas injection pipe (19) is in communication with the gas chamber.

17. The reaction chamber according to claim 16, wherein
a gas homogenizing plate (20) is disposed at a position where the gas chamber communicates with the gas injection pipe (19); and
a supporting plate (21) is circumferentially fixed in the upstream space; the supporting plate (21) is provided with a supporting opening for supporting the upstream substrate conveyance channel (17), and a through hole for the gas injection pipe (19) to pass through.

18. The reaction chamber according to any one of claims 12 to 17, wherein a gas extraction system (22) in communication with the gas transport and growth chamber (2) is disposed in the downstream space.

19. The reaction chamber according to claim 18, wherein the downstream flange (14) is a hollow annular structure, one end opening of the downstream flange (14) is connected to the quartz chamber (12) via sealed connection, and the other end opening is connected to a capping flange (23) via sealed connection; and
an exhaust channel is formed by the downstream flange (14); and a tail gas pipeline of the gas extraction system (22) is disposed in the exhaust channel.

20. The reaction chamber of claim 19, wherein
the heating chamber (11) comprises a side wall and a bottom wall; the side wall of the heating chamber (11) is an arched structure, and the bottom wall of the heating chamber (11) is a planar structure;
the quartz chamber (12) comprises a side wall and a bottom wall; the side wall of the quartz chamber (12) is an arched structure, and the bottom wall of the quartz chamber (12) is a planar structure;
a first sealing ring is disposed between the upstream flange (13) and the quartz chamber (12); a second sealing ring is disposed between the downstream flange (14) and the quartz chamber (12);
the upstream flange (13) is a hollow structure, and the hollow structure of the upstream flange (13) is filled with a cooling liquid;
the downstream flange (14) is a hollow structure, and the hollow structure of the downstream flange (14) is filled with the cooling liquid;
the capping flange (23) is a hollow structure, and the hollow structure of the capping flange (23) is filled with the cooling liquid;
the capping flange (23) is provided with an observation window and/or a temperature measurement hole; and
the reaction chamber is provided with a temperature sensor to measure a temperature in the heating chamber (11).
